# DEMANDE DE BREVET EUROPEEN

(11) **EP 0 743 675 A1**
(43) Date de publication de la demande: **20.11.1996**
(21) Numéro de dépôt: 96400999.7
(22) Date de dépôt: 10.05.1996
(51) Int. Cl.: H01L 21/312, H01L 21/316, H01L 21/762

(54) **Procédé d'isolateur électrique par dépôt d'oxyde à l'état visqueux dans des cavités étroites et dispositif semi-conducteur correspondant**

(30) Priorité: 15.05.1995 FR 9505710
(71) Demandeur: FRANCE TELECOM, 75015 Paris (FR)
(72) Inventeur: Brouquet, Pierre, 38920 Crolles (FR)
(74) Mandataire: Casalonga, Axel

(57) **Abrégé**

L'invention concerne un procédé d'isolement électrique de matériaux conducteurs ou semi-conducteurs d'un substrat, caractérisé en ce qu'il comporte au moins les étapes suivantes :
(a) on dépose sur les régions prédéterminées du substrat à isoler au moins une couche d'oxyde isolant dit conforme;
(b) on dépose sur les régions prédéterminées, par réaction chimique en phase plasma de tétraalkosilicate et de péroxyde d'hydrogène, une couche de précurseur d'oxyde aplanissant;
(c) on dépose sur les régions prédéterminées au moins une couche d'oxyde isolant; et
(d) on effectue un recuit de transformation.

Elle concerne également les dispositifs semi-conducteurs et éléments de circuits intégrés à cavités étroites isolées.

## Description

L'invention concerne un procédé qui permet de réaliser l'isolement électrique de matériaux conducteurs ou semi-conducteurs utilisés en micro-électronique et présentant des cavités étroites par dépôt d'oxyde à l'état visqueux, ainsi que des dispositifs comportant de telles cavités.

Les techniques d'isolation de matériaux conducteurs, par exemple de métaux utilisés pour les interconnexions pour des circuits intégrés notamment ou de matériaux semi-conducteurs pour les zones actives de substrat semi-conducteur évoluent, dans le cadre de la réduction des dimensions des circuits intégrés ou à semi-conducteurs et de l'augmentation de densité dans le domaine de la micro-électronique.

On connaît déjà des techniques de dépôt en phase vapeur, par réaction chimique en phase vapeur (CVD) ou en phase plasma (PECVD), utilisées notamment pour l'isolation en micro-électronique réalisée en oxyde de silicium. Les techniques citées ci-dessus mettent toutes en oeuvre des réactions chimiques utilisant des composés à base de silicium, comme le silane, le tétraéthylorthosilicate ou le dichlorosilane, ainsi que des oxydants (O₂, N₂O, O₃). Toutes ces réactions produisent un radical SiO responsable de la formation de l'oxyde de silicium. L'oxygène non saturé du radical SiO est extrêmement réactif; la liaison chimique créée immédiatement lors de l'arrivée sur la surface d'un radical SiO est très solide et le dépôt se produit sans aucune mobilité de surface, du fait de la réticulation tridimensionnelle.

Tous les dépôts produits usuellement à base de SiO sont dits conformes, c'est-à-dire qu'ils se forment parallèlement aux surfaces sur lesquelles ils sont déposés.

Quand les motifs à recouvrir sont serrés, par effet d'ombrage, l'appauvrissement du flux de radicaux SiO empêche la formation de l'oxyde dans les cavités étroites.

L'invention a pour but de proposer un procédé de dépôt d'oxyde à l'état visqueux qui permet de remplir ces cavités étroites.

Le procédé de l'invention permet de remplir des cavités étroites et d'aplanir les surfaces recouvertes par de l'oxyde qui, après recuit, présente des qualités semblables à celles des oxydes de silicium SiO₂ déposés par les méthodes conventionnelles.

L'invention concerne ainsi un procédé d'isolement électrique de matériaux conducteurs ou semi-conducteurs d'un substrat comportant au moins les étapes suivantes :
(a) on dépose sur les régions prédéterminées du substrat à isoler au moins une couche d'oxyde isolant dit conforme;
(b) on dépose sur les régions prédéterminées, par réaction chimique en phase plasma de tétraalkosilicate et de péroxyde d'hydrogène, une couche de précurseur d'oxyde aplanissant;
(c) on dépose sur les régions prédéterminées au moins une couche d'oxyde isolant; et
(d) on effectue un recuit de transformation.

Selon l'invention, on entend par substrat les matériaux conducteurs ou semi-conducteurs dont on cherche à réaliser l'isolement électrique, au moins dans des régions prédéterminées. Il peut s'agir notamment de métaux utilisés pour les interconnexions ou des zones actives semi-conductrices de semi-conducteurs.

Le procédé selon l'invention s'applique particulièrement aux régions présentant des cavités étroites, pour l'isolation latérale par tranchées du substrat semi-conducteur ou l'isolation inter-métal pour des niveaux de connexion.

Par cavités étroites, on entend tous motifs pour lesquels les dépôts usuels sont susceptibles de provoquer des effets d'ombrage.

Ainsi, selon l'invention, l'eau oxygénée utilisée se décompose en phase plasma pour donner naissance à un radical hydroxyle OH. Lorsque le composé gazeux du silicium qu'est le tétraalkosilicate ou tétraalkylorthosilicate est mis en contact avec OH en phase plasma ou en phase CVD, il s'oxyde en formant un radical RSiOH où R représente un radical alkyle dans lequel l'oxygène n'est pas saturé et peut ainsi donner naissance à un dépôt d'oxyde riche en groupe silanol (SiOH).

La réaction en phase plasma mettant en oeuvre du tétraalkylorthosilicate et du péroxyde d'hydrogène permet d'obtenir un tel dépôt et une teneur en silanol suffisante pour produire une couche liquide visqueuse.

Le radical silanol est fragile et un recuit permet de mener la destruction quasi-totale des groupements silanol présents dans l'oxyde : lors de ce recuit, le silanol se transforme en SiO en libérant de l'hydrogène ou de l'eau. Le matériau précurseur ainsi recuit se transforme en oxyde de silicium SiO₂.

Comme composés gazeux du silicium, on peut utiliser les composés tétraalkylorthosilicates usuels en micro-électronique et plus particulièrement les tétraalkylorthosilicates portant des groupements alkyle, pourvu que le radical alkyle ne forme pas de condensable lourd. Il peut s'agir des groupements méthyle, éthyle ou butyle.

L'utilisation de cette technique permet de remplir convenablement les cavités à faibles géométries ou cavités étroites. Ainsi, le procédé selon l'invention permet le remplissage sans défaut de cavités étroites; par cavités étroites, on entend notamment des cavités de largeur de l'ordre de 0,4 µm et des profondeurs supérieures à 1 µm.

L'invention a également pour objet un dispositif semi-conducteur ou interconnexion comportant un substrat semi-conducteur ou conducteur qui présente des régions isolées par de l'oxyde de silicium, caractérisé par le fait qu'il comprend au moins une région prédéterminée du substrat destinée à former ultérieurement une zone active et/ou comportant des cavités étroites et en ce que l'isolant comporte au moins une première couche d'oxyde dit conforme, une couche d'oxyde formée à l'état visqueux par réaction en phase plasma de tétraalkosilicate et de péroxyde d'hydrogène et une seconde couche d'oxyde, la couche formée à l'état visqueux étant disposée entre la première et la seconde couches d'oxyde.

D'autres avantages et caractéristiques de l'invention apparaîtront à l'examen de la description détaillée des modes de mise en oeuvre et de réalisation de l'invention, nullement limitatifs, et des dessins annexés, sur lesquels :

la figure 1 illustre les dépôts usuels SiO conformes;
la figure 2 illustre l'appauvrissement par effet d'ombrage du flux de radicaux SiO lors de l'application du flux d'espèces actives après un dépôt conforme;
Les figures 3a, 3b et 3c illustrent la mise en oeuvre du procédé selon l'invention dans une région de substrat à faible géométrie.

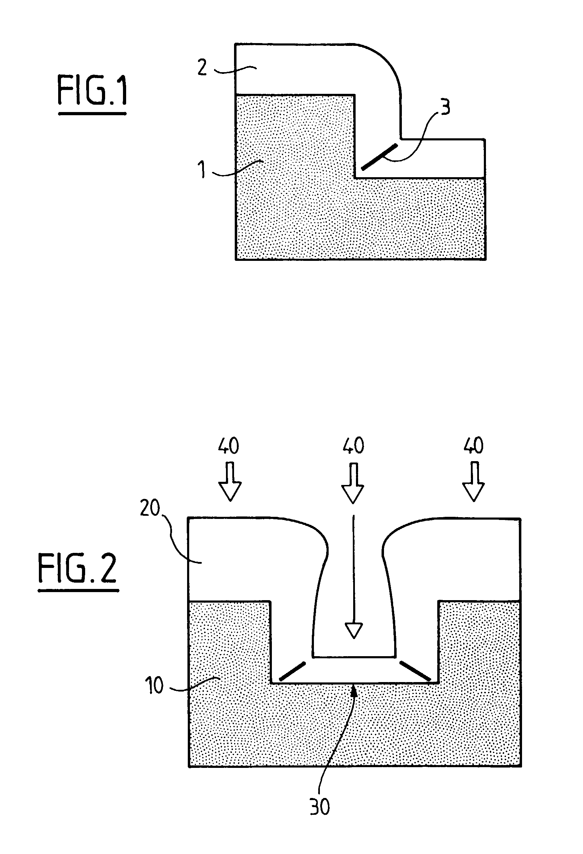

Tel qu'illustré à la figure 1, une couche d'oxyde 2 s'est formée parallèlement aux surfaces du substrat 1 sur lesquelles elle est déposée et une zone de défaut de densité 3 apparaît; il s'agit d'une faille linéaire confondue avec la bissectrice des angles rentrants.

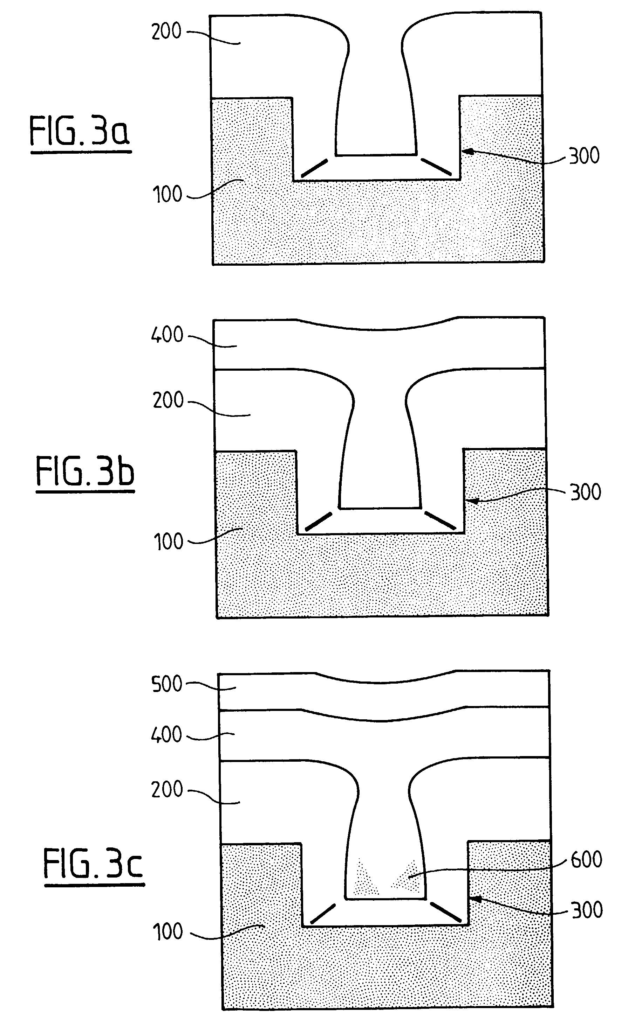

Comme cela apparaît à la figure 2, lors de l'application usuelle d'un flux subséquent d'espèces actives après le dépôt conforme 20 sur un substrat 10 dans un motif à faible géométrie 30, le flux 40 appliqué de façon homogène sur la surface est appauvri à l'arrivée au fond du motif 30, du fait de l'effet d'ombrage provoqué par le dépôt conforme 20.

Tel qu'illustré sur les figures 3a à 3c, le mode de mise en oeuvre du procédé selon l'invention comporte tout d'abord le dépôt usuel d'une couche d'oxyde 200 sur un substrat 100 dont un motif de faible géométrie 300 est représenté. La formation de cette première couche 200 est réalisée par dépôt usuel d'oxyde de silicium et l'une de ses fonctions est de réaliser une protection du substrat 100. Le dépôt de la première couche d'oxyde est conforme.

Ce dépôt conventionnel d'oxyde 200 est réalisé en vue notamment d'une protection des couches inférieures du circuit lors du recuit de transformation, pour éviter l'attaque des métaux.

Comme cela apparaît à la figure 3b, sur cette première couche d'oxyde 200, on réalise un dépôt en phase plasma dont le but est de remplir les cavités étroites par un passage à l'état visqueux. La couche 400, du fait de son état visqueux, remplit la cavité de faible géométrie 300.

Sur cette couche 400 déposée en phase plasma, on dépose de façon conventionnelle une couche d'oxyde 500 qui a pour fonction d'encapsuler la couche visqueuse avant le recuit de l'ensemble, et de réguler la désorption d'oxyde de carbone, d'hydrogène et d'eau, pour éviter la formation de défauts 600 et ralentir la décomposition du radical silanol.

Après le recuit de transformation, les défauts sont localisés dans une zone large 600 apparaissant au pied du motif.

Alors que les deux étapes (a) et (c) peuvent être réalisées de façon conventionnelle, par exemple en CVD, l'étape de dépôt de la couche d'oxyde aplanissant à l'état visqueux a lieu en phase plasma.

Les conditions de dépôt CVD ou en phase plasma sont usuelles pour le domaine de la micro-électronique. On opère de préférence sous gaz inerte, par exemple azote, argon ou hélium, de façon usuelle.

On peut par exemple mettre en oeuvre des conditions de pression de 1199 Pa (9 Torr), une puissance en Radio Frequence de 50 Watts, l'utilisation de gaz par barboteurs à 40°C et un flux de gaz porteur, de préférence inerte, et par exemple de l'hélium, de 200 sccm, la solution de péroxyde d'hydrogène pouvant être choisie à 30%.

Le recuit est conduit dans des conditions de températures comprises entre 300°C et 1000°C; la durée du recuit dépend de la température choisie. Ainsi, pour une température de l'ordre de 400°C, on a opéré un recuit pendant environ 30 minutes, le recuit étant opéré sous azote.

La couche aplanissante issue de la réaction en phase plasma peut être identifiée en analyse infrarouge, par la présence du groupement SiOH (nombre d'onde 3360 et 940 cm⁻¹).

Par ailleurs, après recuit de la couche d'oxyde aplanissant, on peut observer sur les dispositifs à cavités étroites isolées, les défauts de densité, en les révélant par immersion dans une solution d'acide fluorhydrique.

Alors que dans le cas des oxydes conventionnels, les défauts sont localisés sur une faille linéaire confondue avec la bissectrice des angles rentrants (voir figure 1, zone 3 et figures 2 et 3 dans la couche 20, 200), dans le cas des oxydes déposés en phase visqueuse, ces défauts sont moins nets et ils sont localisés dans une zone large au pied du motif (voir figure 3c, zone 600).

Le procédé selon l'invention peut aussi remplacer les procédés d'aplanissement conventionnels, notamment des procédés dits SOG (spin on glass). Il peut être utilisé conjointement au polissage mécano-chimique.

## Revendications

1. Procédé d'isolement électrique de matériaux conducteurs ou semi-conducteurs d'un substrat, caractérisé en ce qu'il comporte au moins les étapes suivantes :
(a) on dépose sur les régions prédéterminées du substrat à isoler au moins une couche d'oxyde isolant dit conforme;
(b) on dépose sur les régions prédéterminées, par réaction chimique en phase plasma de tétraalkosilicate et de péroxyde d'hydrogène, une couche de précurseur d'oxyde aplanissant;
(c) on dépose sur les régions prédéterminées au moins une couche d'oxyde isolant; et
(d) on effectue un recuit de transformation.

2. Procédé selon la revendication 1, caractérisé en ce que le tétraalkosilicate est du tétraéthylorthosilicate.

3. Procédé selon la revendication 1 ou 2, caractérisé par le fait que le recuit de transformation est effectué à une température comprise entre 300° et 1000°C.

4. Procédé selon l'une des revendications 1 à 3, caractérisé en ce que le recuit est effectué à une température de l'ordre de 400°C.

5. Procédé selon l'une des revendications 1 à 4, caractérisé en ce que le dépôt de la seconde couche d'oxyde encapsule le dépôt de la couche à l'état visqueux.

6. Dispositif semi-conducteur ou interconnexion comportant un substrat semi-conducteur ou conducteur qui présente des régions isolées par de l'oxyde de silicium, caractérisé par le fait qu'il comprend au moins une région prédéterminée du substrat destinée à former ultérieurement une zone active et/ou comportant des cavités étroites et en ce que l'isolant comporte au moins une première couche d'oxyde dit conforme, une couche d'oxyde formée à l'état visqueux par réaction en phase plasma de tétraalkosilicate et de péroxyde d'hydrogène et une seconde couche d'oxyde, la couche formée à l'état visqueux étant disposée entre la première et la seconde couches d'oxyde.
